# EUROPEAN PATENT SPECIFICATION

(11) **EP 1 853 746 B1**
(45) Date of publication and mention of the grant of the patent: **19.12.2012**
(21) Application number: 06728736.7
(22) Date of filing: 01.03.2006
(51) Int. Cl.: C23C 16/27, F16C 33/04, F16J 15/34, F04D 29/10

(54) **USE OF A DIAMOND-COATED BEARING OR SEAL STRUCTURE**
VERWENDUNG EINER DIAMANTBESCHICHTETEN LAGER- ODER DICHTUNGSSTRUKTUR
UTILISATION D'UNE STRUCTURE D'ÉTANCHÉITÉ OU DE SUPPORT À REVÊTEMENT DE DIAMANT

(30) Priority: 02.03.2005 JP 2005057550
(43) Date of publication of application: 14.11.2007
(73) Proprietor: EBARA CORPORATION, Ohta-ku, Tokyo 144-8510 (JP)
(72) Inventor: NAGASAKA, Hiroshi, Ohta-ku, Tokyo, 144-8510 (JP); OGAWA, Toshiyuki, Ohta-ku, Tokyo, 1448510 (JP); SUGIYAMA, Kenichi, 4-chome, Fujisawa-shi, Kanagawa, 251-8502 (JP)
(74) Representative: Wagner & Geyer
(86) International application number: PCT/JP2006/304417
(87) International publication number: WO 2006/093319

(56) References cited:
- EP-A- 0 614 999
- EP-A- 0 870 956
- EP-A- 1 475 557
- US-A- 4 406 577
- US-A- 6 083 570

## Description

### BACKGROUND OF THE INVENTION

### Field of the Invention

The present invention relates to the use of a diamond-coated bearing or seal structure within pure of ultrapure water. Such a structure requires abrasive resistance and a small coefficient of friction, and may in particular be used as a bearing or seal structure suitable for use in a rotary machine such as a pump, a turbine, or a compressor, or a rectilinear-motion machine such as a hydraulic cylinder, as well as a fluid handling machine such as a pump, turbine, or a compressor which comprises such a bearing or seal structure.

### Description of the Related Art

In bearing or seal structures for rotary machines such as pumps, turbines, or compressors, or rectilinear-motion machines such as fluid pressure cylinders, a movable member and a stationary bearing or seal member are conventionally made of a material such as metal, cemented carbide, a polymeric material, ceramics, or their combinations; the movable member serves as or is attached to a rotating shaft and corresponds to a movable side, and the stationary bearing or seal member is paired with the movable member and corresponds to a stationary side.

In recent years, for environmental protection, oil-free seals and/or bearings have been utilized in these rotary or rectilinear-motion machines. The needs for the reduced sizes and increased velocities and capacities of rotary machines have made operating conditions for the bearings and seals more severe so that the bearing and seals can withstand higher velocities and heavier loads. Moreover, a bearing or seal mounted in a liquid hydrogen pump or hydrogen gas compressor is used in a process fluid of a very low viscosity and thus needs to be made of a slidable material with abrasive resistance and a reduced friction.

The following problems have been pointed out for the conventional materials (for example, cemented carbide and SiC) for bearing or seal members for rotary machines handling a process fluid such as air, a hydrogen gas, or liquid hydrogen: the sliding contact between solids causes thermal shock failures or thermal fatigue cracks. To improve the frictional characteristics of the conventional material, attempts have been made to execute a hardening treatment such as carbonizing or nitriding treatment or to form a nitride- or oxide-based ceramics coating. However, these surface treatments do not make the slidable material satisfactory in terms of the hardness, abrasive resistance, frictional characteristics of a modified layer.

On the other hand, a technique has been proposed which improves the abrasive resistance by forming a diamond coat on the surface of a member demanded in recent years to have abrasive resistance, for example, a cutting tool, as shown in, for example, Japanese Patent Laid-Open No. 2002-142434.

If the member demanded to have abrasive resistance is a cutting tool, the need for polishing the surface of the diamond coat is eliminated by reducing the size of diamond crystals constituting the diamond coat to a certain value or a smaller value. However, if a diamond coat is formed on the surface of a bearing or seal member so that the surface of the coat serves as a slidable surface, the surface is preferably polished to reduce sliding resistance. However, diamond is the hardest material and polishing the diamond coat surface is economically unfeasible.

Furthermore, reference is made to EP 0 870 956 A1, which relates to a specific seal structure to be used in an environment of pure water or ultrapure water. In order to avoid impurities to be introduced into the pure water or ultrapure water, a specific groove structure is provided in the mating surfaces of the seal structure. The groove structure being designed to make sure that any impurities generated at the mating surfaces are guided away from the pure or ultrapure water.

The present invention has been made in view of the above problems. A main object of the present invention is to provide a bearing or seal structure with a reduced coefficient of friction and an improved abrasive resistance for use in pure or ultrapure water.

### SUMMARY OF THE INVENTION

In accordance with the present invention, use of a diamond-coated bearing or seal structure as set forth in claim 1 is provided. Further embodiments of the invention may be derived from the dependent claims.

The present invention provides the use of a diamond-coated bearing or seal structure within pure or ultrapure water, said structure having a movable member and a stationary member, wherein at least one of the movable and stationary members is made of a material with a coefficient of thermal expansion of at most 8 × 10⁻⁶ /°C or less, and polycrystalline diamond is coated on a surface of the member made of the material which lies opposite the other member.

In the present invention, the member different from the member coated with the polycrystalline diamond may be a SiC sintered member or a SiC-coated member or may be made of cemented carbide such as tungsten carbide, chromium carbide or titanium carbide, or an oxide-based sintered material such as Al₂O₃ or ZrO₂ or may be coated with a nitride-based material such as TiN.

In the present invention, in the member coated with the polycrystalline diamond, a layer of hard carbon with a Vickers hardness Hv of 2,000 < Hv < 8,000 may be coated on the polycrystalline diamond.

The present invention provides the following effects.
(1) The coefficient of friction of the bearing or seal structure can be reduced and the abrasive resistance is improved.
(2) The lifetime of a fluid machine using the bearing and/or seal structure in pure or ultrapure water can be elongated.
(3) The conventional combination of materials may cause damage to a slidable surface upon the activation or stoppage of the machine in the air. However, the present invention provides a bearing or seal member that can operate stably in the air.

### BRIEF DESCRIPTION OF THE DRAWINGS

FIG. 1 is a sectional view showing an embodiment of a bearing structure for use with the present invention;
FIG. 2 is an enlarged sectional view of a part A in FIG. 1;
FIG. 3 is a sectional view showing an embodiment of a seal structure for use with the present invention;
FIG. 4 is an enlarged sectional view of a part B in FIG. 3;
FIG. 5 is a conceptual drawing of a hot-filament CVD apparatus;
FIG. 6 is a view showing SEM images of a diamond coating surface, wherein FIG. 6(a) shows a diamond coating surface in accordance with Specific Embodiment 2 shown in Table 3-1 and FIG. 6(b) shows a diamond coating surface in accordance with Specific Embodiment 5 shown in Table 3-1;
FIG. 7 is a diagram showing needle surface roughness measurements obtained before and after diamond coating, wherein FIG. 7(a) shows a surface roughness before the diamond coating(SiC) is performed and FIG. 7(b) shows a surface roughness after the diamond coating is performed;
FIG. 8 is a diagram showing a Raman spectrum of a diamond coating layer in accordance with Specific Embodiment 1 shown in Table 3-1;
FIG. 9 is a diagram showing X-ray analysis patterns, wherein FIG. 9(a) shows an X-ray analysis pattern of Specific Embodiment 2 shown in Table 3-1 and FIG. 9(b) shows an X-ray analysis pattern of Specific Embodiment 4 shown in Table 3-1;
FIG. 10 is a conceptual drawing of a microwave CVD apparatus;
FIG. 11 is a view showing a SEM image of diamond coating surface in accordance with Specific Embodiment 11 shown in Table 3-1;
FIG. 12 is a diagram showing a Raman spectrum of diamond coating surface in accordance with Specific Embodiment 11 shown in Table 3-1;
FIG. 13 is a conceptual drawing of an abrasion testing portion;
FIG. 14 is a sectional view of a non-contact end surface seal apparatus for a centrifugal compressor;
FIG. 15 is a diagram showing a barreled motor pump comprising a thrust bearing to which the present invention is applied;
FIG. 16 is a sectional view showing a preceding spinning reserve operation vertical-axis pump to which the bearing structure in accordance with the present invention is applicable;
FIG. 17 is a sectional view showing a plurality of vertical-shaft pumps for a preceding spinning reserve operation vertical-axis pumps arranged in parallel; and
FIG. 18 is a schematic diagram showing a water supply apparatus to which the bearing and/or seal structure in accordance with the present invention is applicable.
Fig. 19 show friction and abrasion characteristics of diamond coated member in pure water.

### DETAILED DESCRIPTION OF THE PREFERRED EMBODIMENTS

Embodiments of the present invention will be described below with reference to the drawings.

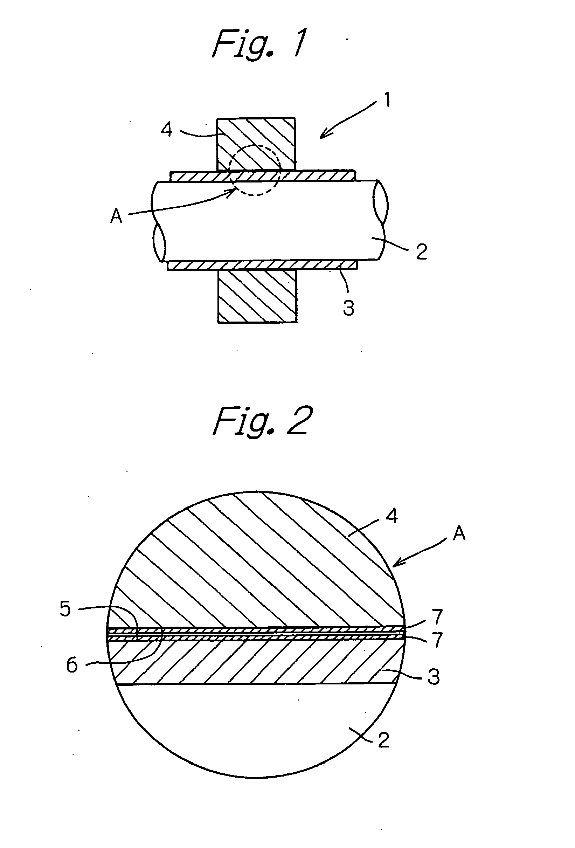

FIG. 1 shows an embodiment of the present invention as a bearing structure of a sliding bearing (or journal bearing) type. The bearing structure 1 is composed of a rotating shaft 2 serving as a movable member or a sleeve 3 mounted around an outer periphery of the rotating shaft 2, and a bearing member 4 serving as a stationary member for rotatably supporting the rotating member. The term "movable member" as used in the specification corresponds to a rotating shaft if the rotating shaft 2 is formed as an integral member or to a sleeve if the sleeve is mounted around the outer periphery of the rotating shaft 2 as shown in the figure. At least one of the sleeve 3 itself as a movable member and the bearing member 4 as a stationary member (in the present embodiment, both) is made of a low thermal expansion material. According to the present embodiment, a coat 7 of polycrystalline diamond is formed both on a surface (journal surface) 5 of the sleeve 3 which faces the bearing member 4 and on a surface 6 of the bearing member 4 which faces the sleeve, as shown in FIG. 2. The diamond coat 7, described above and below, is formed by depositing polycrystalline diamond by a well known chemical deposition method. The low thermal expansion material has a coefficient of thermal expansion of 10 × 10⁻⁶/°C or less and 0.5 × 10⁻⁶/°C or more, preferably of 8 × 10⁻⁶/°C or less, more preferably of 8 × 10⁻⁶/°C or less and 1 × 10⁻⁶/°C or more. The surface of the diamond coat 7 thus formed constitutes a slidable surface at which the rotating member and the stationary member slidably contact each other. Although, in the above example, the diamond coat is formed on the opposite surfaces of both of the sleeve member and the bearing member, it may be formed only on one of these surfaces.

Examples of a method for synthesizing diamond include a hot-filament chemical vapor deposition (CVD) method, a microwave plasma CVD method, a high-frequency plasma, a DC discharge plasma method, an arc discharge plasma jet method, and a burning flame method. A material used for such a vapor phase synthesizing method is a mixed gas consisting of a hydrogen gas with which a certain percent of hydrocarbon such as methane, alcohol, or acetylene is mixed. The hydrogen gas may be mixed with carbon monoxide, carbon dioxide, or the like or a small amount of another gas may be added to the hydrogen gas, depending on the process. The following is common to these mixed gases: the material gas is mostly composed of hydrogen and is converted into plasma or activated by thermal excitation. The activated hydrogen etches non-diamond carbon well but does not substantially etch diamond. The above vapor phase synthesizing method forms a diamond film by appropriately using this selective etching action to suppress the growth of non-diamond components on a base material, while depositing only diamond. The above methods are well known and their detailed descriptions will be omitted.

If a coat is to be formed on an inner peripheral surface of the cylindrical bearing member 4 (this may be a seal member of a similar shape), the hot-filament CVD method is suitably used because of the relatively high degree of freedom of the shape of the target. A plurality of filaments are applied to the inside of the cylinder at equal intervals, and diamond is formed on the inner surface. To form a coat on the outer periphery of the sleeve 3 (if a shaft is integrated with the sleeve 3, a coat is formed on the outer periphery of the shaft), it is possible to apply a plurality of filaments to the outside of a substrate at equal intervals using the hot-filament CVD method and to deposit diamond on the surface of the target base material.

When diamond is coated on the opposite surface 5 of the sleeve 3, serving as a movable member, and on the opposite surface 6 of the bearing member 4 (or seal member), serving as a stationary member, by the hot-filament CVD method so that the surfaces constitute slidable surfaces, the resulting structure has a small coefficient of friction and a high abrasive resistance as described below. This makes it possible to provide a seal or bearing excellent in the frictional characteristics.

In the bearing structure (or seal structure) consisting of the combination of the sleeve 3, serving as a movable member, and the bearing member 4 (or seal member), serving as a stationary member, the sliding contact between solids occurs on the slidable surfaces of the sleeve and bearing member (seal member). Consequently, the presence of concaves and convexes on the surfaces increases the contact resistance. The surface roughness of the slidable surfaces is thus desirably minimized. In general, before being coated with diamond, the surface of the base material has preferably been lapped or polished so that its surface roughness Ra is 0.3 µm or less. On the other hand, the surface roughness of a polycrystalline diamond-coated surface formed by the chemical deposition method depends on crystal grain size, film thickness, crystal orientation and the like.

Through concentrated studies, the inventors have found that the average surface roughness of the slidable surfaces is preferably set at 0.3 µm or less, more preferably 0.1 µm or less in order to reduce the coefficient of friction to improve the abrasive resistance. Means for setting the average surface roughness of the diamond-coated surface at 0.3 µm or less is as follows.
**(1)** The diamond crystal preferably has an average grain size of at most 5 µm, more preferably 0.1 µm.
(2) The diamond preferably has a film thickness of at most 10 µm, more preferably 5 µm.
(3) For the diamond crystal grains, a (100) plane is highly oriented.

With the hot-filament CVD method, the temperature of the substrate is between 800 and 1,000°C during a film forming process. Accordingly, examples of the base material include inorganic materials such as silicon, silicon nitride, alumina, and silicon carbide and high-melting-point metals such as molybdenum and platinum. Further, since the substrate is hot during film formation, it tends to be significantly deformed when there is a large difference in the coefficient of thermal expansion between the base material and the diamond film. When a material having a coefficient of thermal expansion similar to that of diamond is used as the base material, the amounts of deformation and leakage are both small, resulting in an excellent seal effect and a high abrasive resistance. Since diamond has a coefficient of thermal expansion of 1.1 × 10⁻⁶/°C, the substrate material desirably has a coefficient of thermal expansion of 8 × 10⁻⁶/°C or less. The material is not limited to ceramics such as SiC and Si₃N₄ but may be metal provided that it has a coefficient of thermal expansion of 8 × 10⁻⁶/°C or less.

It is desirable to reduce the surface roughness of the diamond-coated surface as much as possible. To obtain a smooth surface, it is necessary to polish the surface of the diamond coating after it is formed. Polishing the diamond-coated surface, which is formed by an ultra-hard material, requires high costs and is not practical. According to the present invention, a hard carbon film is formed on the diamond coating, thus facilitating post-treatment based on polishing with diamond abrasive grains. Alternatively, fine concaves and convexes can be removed by rubbing both coating surfaces against each other. The removal of the fine concaves and convexes remarkably reduces the frictional resistance of the rubbed surfaces, making it possible to obtain an ideal smooth surface. The hard carbon film means a film obtained by compounding carbons consisting of non-diamond components softer than diamond, or diamond like carbon (referred to as "DLC" below) or graphite-like carbon. The hard carbon film can be produced by the hot-filament CVD method, plasma CVD method, or multi-arc ion plating method. The hot-filament method enables a hard carbon film of non-diamond components to be easily formed by increasing methane concentration.

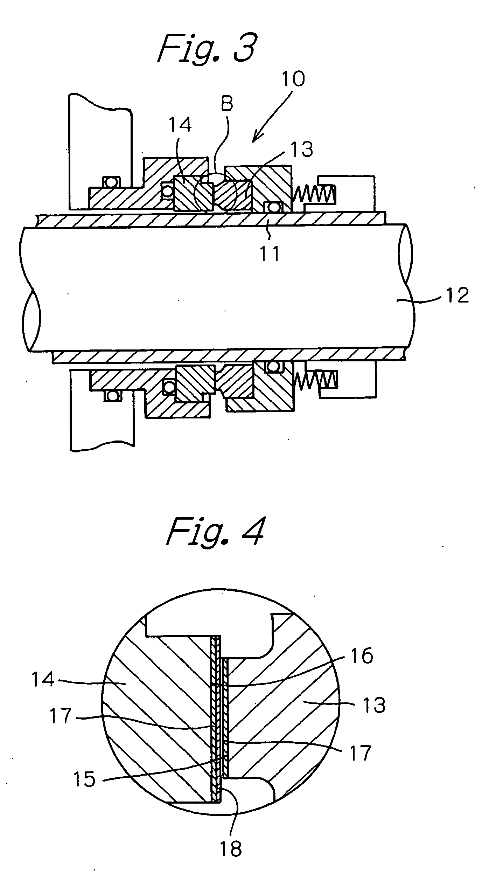

Another embodiment of the present invention is shown as a seal structure of a mechanical seal type as shown in FIG. 3. A seal structure 10 comprises an annular movable seal member 13 placed around the outer periphery of a sleeve 12 installed outside a rotating shaft 11, the movable seal member 13 serving as a movable member, and an annular stationary seal member 14 serving as a stationary member. At least one (in the present embodiment, both) of the movable member and stationary member is made of a low thermal expansion material as in the case of the above embodiment. The low thermal expansion material has a coefficient of thermal expansion of not more than 10 × **10⁻⁶/°C** and not less than 0.5 × 10⁻⁶/°C, preferably of not more than 8 × **10⁻⁶/°C,** more preferably of not more than 8 × **10⁻⁶/°C** and not less than 1 × 10⁻⁶/°C.

A coat 18 of a hard carbon material (Vickers hardness Hv: 2,000 < Hv < 6,000) may optionally be formed on the surface of one of a polycrystalline diamond coat 17 formed as described above on an opposite surface (or seal surface) 15 of the movable seal member and a polycrystalline diamond coat 17 formed as described above on an opposite surface 16 of the stationary seal member 14 (in the present embodiment, the diamond-coated surface of the stationary seal member). In the present embodiment, the surface of a coat of the hard carbon material and the surface of the diamond coat on which the coat of the hard carbon material is formed, constitutes sliding surfaces on which the rotating member and stationary member slidably contact each other. The thickness of the hard carbon coat 6 is preferably 0.5 to 20 µm, more preferably 0.5 to 5 µm. This is because a desirable high abrasive resistance cannot be achieved if the coat is less than 0.5 µm in thickness and because the film forming method increases the value of internal stress of the hard carbon film itself to possibly cause the film to be removed from the substrate if the thickness of the coat is more than 5 µm.

To obtain a smooth surface, it is necessary to polish the surface of the diamond coating after it is formed. Polishing the diamond-coated surface, an ultra-hard material, requires high costs and is not practical. According to the present embodiment a coat 18 of a hard carbon material is formed on the surface of the polycrystalline diamond coat 17 so that the surface of the coat 18 constitutes a slidable surface. This facilitates post-treatment based on polishing with diamond abrasive grains.

Examples of a method for synthesizing diamond like carbon or graphite-like carbon include the hot-filament CVD method, microwave plasma CVD method, high-frequency plasma method, CD discharge plasma method, ion plating method using an arc, sputtering deposition method, and ion deposition method. A carbon compound is used as a material for the chemical deposition method. Examples of the material include saturated hydrocarbons such as methane, ethane, propane, and butane, unsaturated hydrocarbons such as ethylene, propylene, acetylene, and butadiene, and aromatic hydrocarbons such as benzene and toluene. A carbon target substrate is used for physical deposition methods such as the ion plating method using an arc and sputtering deposition method. The above methods are well known and will not be described in detail.

A DLC film is an amorphous carbon film containing a bonding (sp3) similar to the bonding of diamond. The DLC film is generally hard and very slidable. The DLC film is expected to be applied to various products including heavy-load slidable members such as a bearing and a seal and light-load slidable members such as a protective film for a magnetic recording medium. Amorphous carbon films called DLC films exhibit various characteristics such as different sp3 bonding rates. The DLC film obtained thus varies depending on a manufacture method and film formation conditions. Disadvantageously, conventional DLC single-layer films may fail to exhibit a sufficient performance in connection with the removal of the film itself or the like. The present invention can provide a slidable material with a high abrasive resistance and a high slidability by forming a polycrystalline diamond film that adheres tightly to the substrate and then forms a DLC film.

The coat of the hard carbon material may of course be formed on the surface of the diamond film of the bearing structure shown in FIG. 1. Further, of course, the coat of the hard carbon material may optionally be formed in the seal apparatus in FIG. 3 as explained hereinbefore.

In another embodiment, although not shown in the drawings, the same low thermal expansion material as that in the above embodiments is used to make one (for example, the sleeve or movable seal member) of the sleeve or movable seal member serving as a movable member and the bearing member (or stationary seal member) serving as a stationary member, both members being shown in the above embodiments, and a polycrystalline diamond coat is formed on the opposite surface (journal or seal surface) of the sleeve or movable seal member as described above. On the other hand, a SiC sintered material or another material (for example, a low thermal expansion material) may be used to make the other of the sleeve or movable seal member serving as a movable member and the bearing member (or stationary seal member) serving as a stationary member, and the opposite surface of the bearing member may be coated with a SiC sintered material. In the present embodiment, the surfaces of the diamond coat and SiC sintered material constitute slidable surfaces on which the rotating member and stationary member slidably contact each other.

In another embodiment of the present invention, the bearing member (or stationary seal member; the sleeve or movable seal ring if a diamond coat is not formed on the sleeve or movable seal ring serving as a movable member) serving as a stationary member and on which a diamond coat is not formed may be formed of a cemented carbide member such as tungsten carbide, chromium carbide, or titanium carbide, an Al₂O₃ sintered member, or a TiN material. Alternatively, the bearing member may be formed of another material and the opposite surface is coated with a cemented carbide member based on tungsten carbide, chromium carbide, titanium carbide, or the like, an Al₂O₃ sintered member, or a TiN material.

### [Example 1]

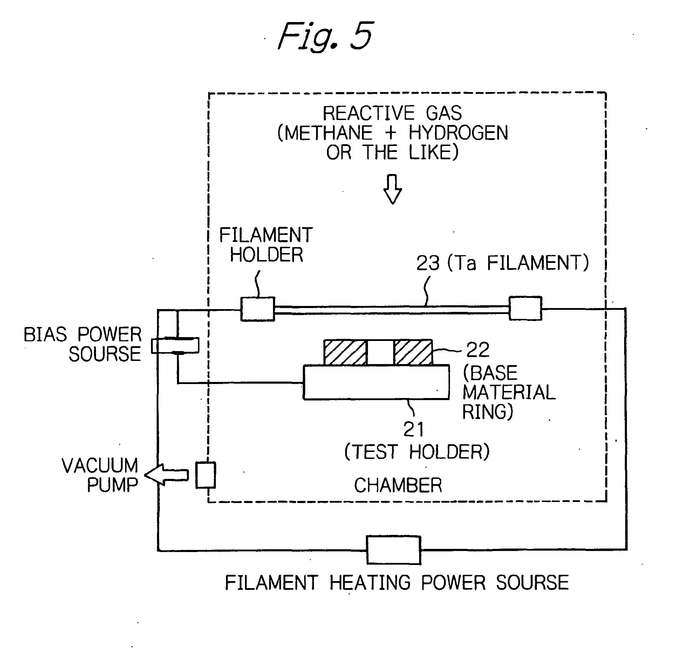

FIG. 5 shows a conceptual drawing showing how to form a diamond coated layer by the hot-filament CVD method. A base material ring 22 formed with a polycrystalline diamond coated layer is fixedly placed on a sample holder 21 made of Mo. A filament 23 is placed opposite the base material ring (simply referred to as the base material below) 22. A mixed gas of methane (CH₄) and hydrogen (H₂), which constitutes a material, is introduced to the filament 23 and the base material 22. The filament heats and decomposes the mixed gas to deposit diamond on the base material. Sintered SiC was used as the base material 22 and shaped into a predetermined ring. A surface on which a coating layer was to be formed was lapped so that its surface roughness Rmax = 0.1 µm or less. Before conducting film formation experiments, the coating surface of the sample was scratched using diamond powder in order to increase diamond nucleus generation density. A polycrystalline diamond coating layer was formed on the scratched surface of the base material 22 under the conditions shown in Table 1-1. A Ta line of φ 0.5 mm was used as the filament. The temperature of the filament was measured using a radiation thermometer and adjusted using a voltage regulator. Film formation experiments were carried out until diamond target coating layer thickness became about 1 to 10 µm.

**Table 1-1 Conditions for Synthesis of a Diamond Coating Layer**

| | |
|---|---|
| Reactive Gas Flow | 100 - 200 sccm |
| Ratio of Methane to Hydrogen | 1 - 5% |
| Filament Temperature(°C) | 1000 - 1200 |
| Pressure (Torr) | 30 - 80 |
| Film Formation Time (hr) | 1 - 5 |
| Base Plate | SiC |

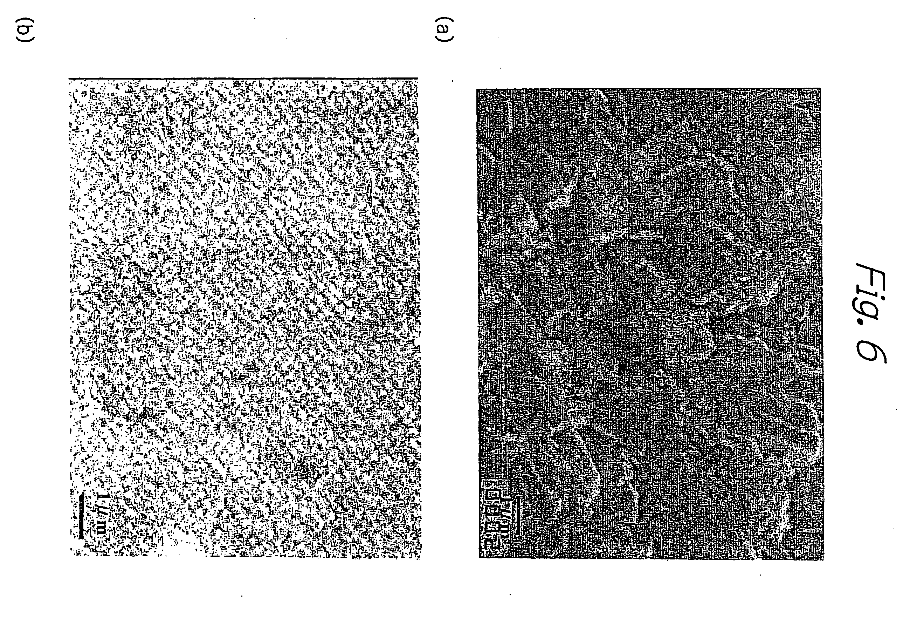

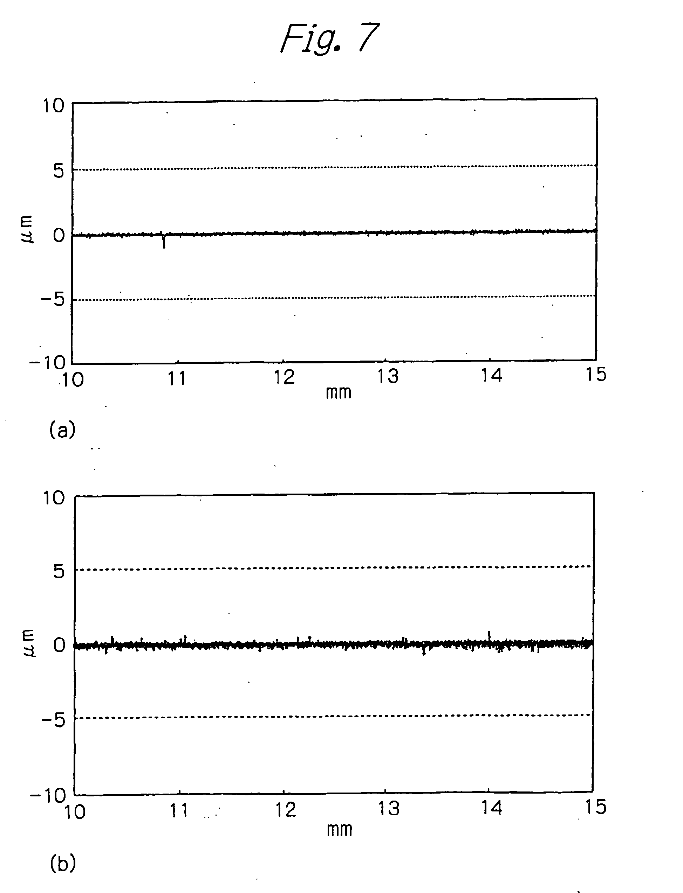

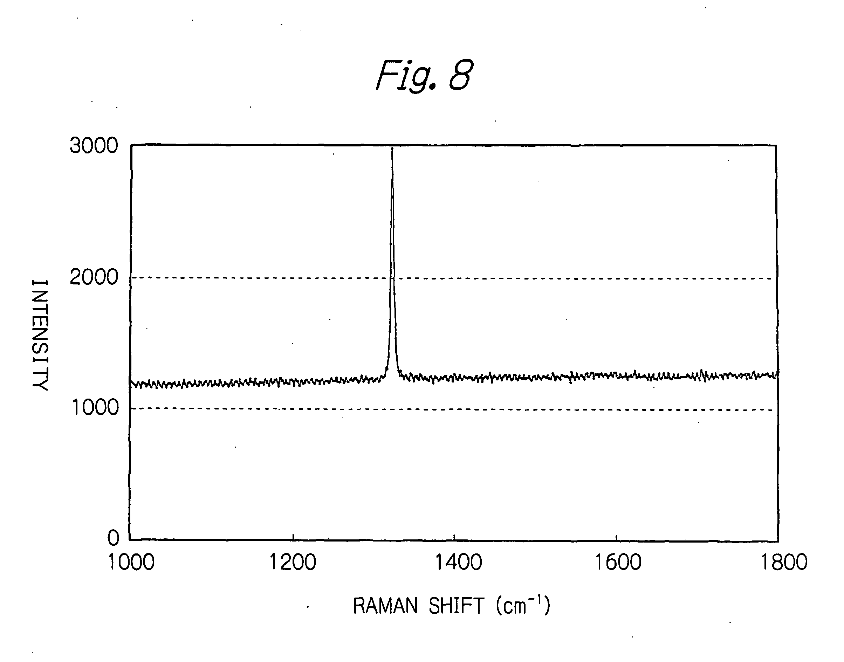

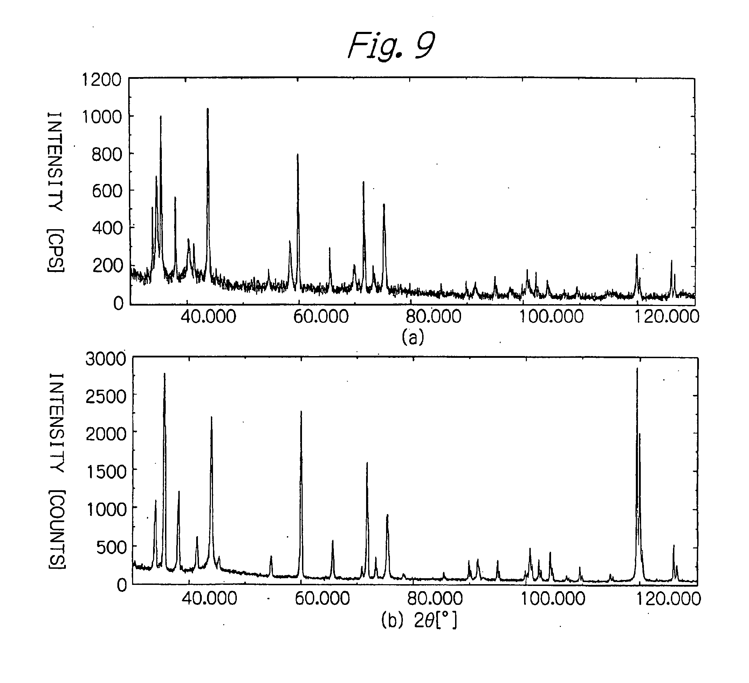

A scanning electron microscope (SEM), Raman spectroscopy, and X-ray analysis were used to evaluate the polycrystalline diamond coating layers formed on the end surfaces of the substrates 22 (material: sintered SiC). Table 1-2 shows film formation conditions based on the hot-filament CVD method and evaluations. FIG. 6 shows the observations of the surfaces of the diamond coats using the SEM. FIG. 7 shows measurements of the diamond coating surface using a needle surface roughness tester. FIGS. 8 and 9 show evaluations based on Raman spectroscopy and X-ray analysis, respectively. FIG. 8 shows a marked peak near 1333 cm⁻¹ of the diamond.

**Table 1-2 Film Formation Conditions Based on the Hot-Filament CVD Method and Evaluations of the Diamond Coating Layer**

| Example | Test Piece | Introduced Gas Flow (sccm) | | Filament Temperature (°C) | Film Formation Time (hr) | Evaluation | | | |
|---|---|---|---|---|---|---|---|---|---|
| | | H2 | CH4 | | | Film thickness (µm) | Crystal Grain Size | Crystal Orientation | Surface Roughness Evaluation |
| 1 | Strip Test Piece | 100 | 1 | 2100-2200 | 5 | 1 µm or less | 1 µm - 10 µm | (111) | ○ |
| 2 | Strip Test Piece | 100 | 2 | 2100-2200 | 5 | 10 µm - 20 µm | 1 µm - 10 µm | (111) | ○ |
| 3 | Strip Test Piece | 100 | 3 | 2100-2200 | 5 | 10 µm - 20 µm | 1 µm - 10 µm | (111) | ○ |
| 4 | Strip Test Piece | 100 | 5 | 2100-2200 | 5 | 10 µm - 20 µm | 1 µm - 10 µm | (100) | ⓞ |
| 5 | Ring End Surface | 100 | 2.5 | 2000-2100 | 5 | 1 µm or less | 1 µm or less | (111) | ⓞ |
| 6 | Ring End Surface | 100 | 1 | 2000-2100 | 5 | 1 µm or less | 1 µm or less | (111) | ⓞ |
| 7 | Ring End Surface | 100 | 1 | 2000-2100 | 5 | 1 µm or less | 1 µm or less | (111) | ⓞ |
| 8 | Cylinder outer Periphery | 100 | 1 | 2000-2100 | 5 | 1 µm or less | 1 µm or less | (111) | ⓞ |
| 9 | Cylinder Inner Periphery | 100 | 1 | 2000-2100 | 5 | 1 µm or less | 1 µm or less | (111) | ⓞ |

| Footnotes | | |
|---|---|---|
| 1. Criteria for the Surface Roughness | | |
| | Average Surface Roughness Ra | Evaluation |
| | Ra<1µm | ○ |
| | 0.3µm<Ra<1 µm | ⓞ |

### [Example 2]

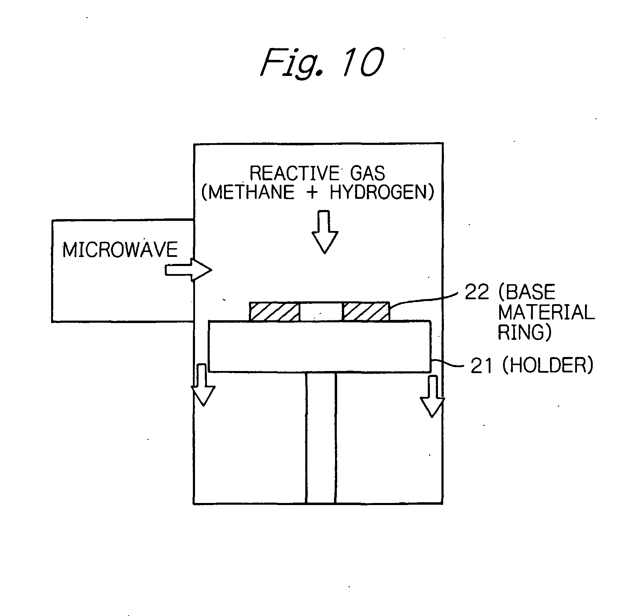

FIG. 10 shows a conceptual drawing showing how to form a diamond coating layer by the microwave plasma CVD method. To increase the nucleus generation density indicating the growth of diamond grains, the SiC surface was scratched using diamond powder. The surface was ultrasonically flawed using diamond grains mixed into alcohol. A mixed gas of CH₄ and H₂ was used as a material gas. Table 2-1 shows conditions for the synthesis of diamond.

**Table 2-1 Conditions for Synthesis of a Diamond Coating Layer**

| | |
|---|---|
| Reactive Gas Flow | 100 - 200 sccm |
| Ratio of Methane to Hydrogen | 1 - 5% |
| Microwave Output (W) | 300 - 500 |
| Pressure (Torr) | 40 - 80 |
| Film Formation Time (hr) | 5 |
| Base Plate | SiC |

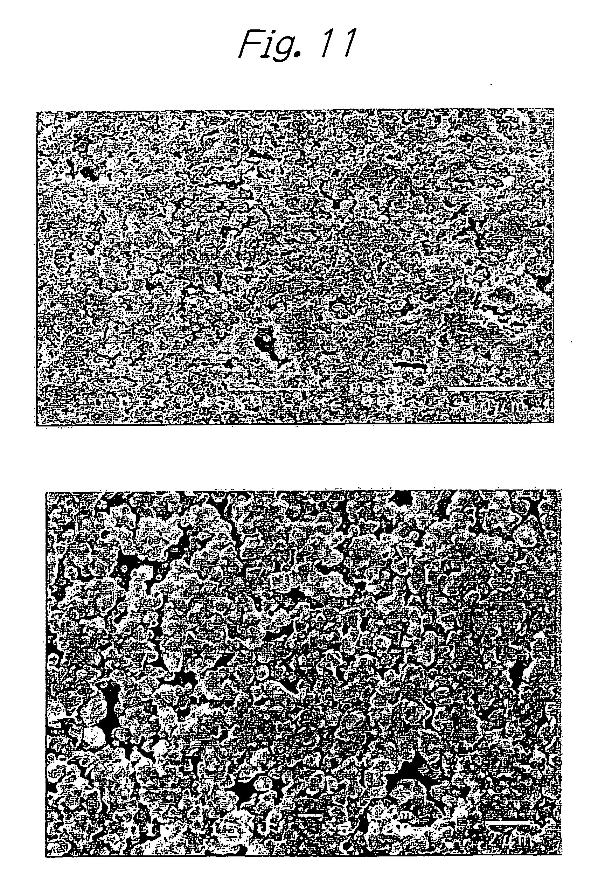

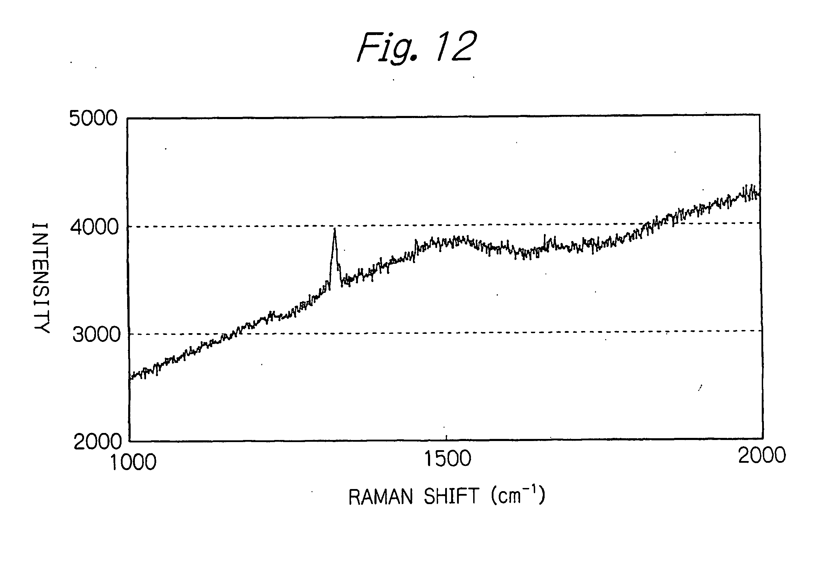

The polycrystalline diamond coating layers synthesized on the base material (base material ring) 22 was evaluated using a scanning electron microscope (SEM), Raman spectroscopy, X-ray analysis, and a needle surface roughness tester. Table 2-2 shows film formation conditions and evaluations of the diamond coating layers. FIG. 11 shows the observations of the diamond coated surfaces using the SEM. Raman spectroscopy (microscopic Raman method; spot diameter: 1 µm) was carried out for qualitative evaluations relating to the mixture of non-diamond components such as graphite or amorphous carbon which has no crystallinity. FIG. 12 shows Raman spectra.
FIG. 12 shows a marked peak near 1333 cm⁻¹ of the diamond. Although a small peak attributed to amorphous carbon and graphite is observed near 1500 cm⁻¹, generation of relatively high-quality diamond was confirmed.

**Table 2-2 Film Formation Conditions Based on the Microwave CVD Method and Evaluations of the Diamond Coating Layer**

| Example | Test Piece | Introduced Gas Flow (sccm) | | Microwave Output (W) | Film Formation Time (hr) | Evaluation | | | |
|---|---|---|---|---|---|---|---|---|---|
| | | H2 | CH4 | | | Film thickness (µm) | Crystal Grain Size | Crystal Orientation | Surface Roughness Evaluation |
| 10 | Ring End Surface | 100 | 1 | 300 | 5 | 1 µm or less | 1 µm or less | (111) | ○ |
| 11 | Ring End Surface | 100 | 2 | 300 | 5 | 1 µm or less | 1 µm or less | (111) | ○ |
| 12 | Ring End Surface | 100 | 3 | 300 | 5 | 1 µm or less | 1 µm or less | (111) | ○ |

### [Example 3]

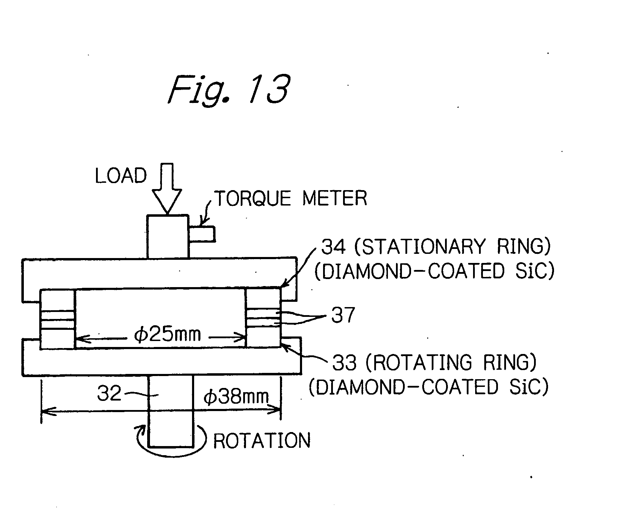

Now, a specific embodiment of the present invention will be described. As previously described, the bearing structure (or seal structure) is composed of the movable member (in the example shown in FIGS. 1 to 4, the rotating shaft, sleeve, or movable seal member) constituting the rotating side and the stationary member (in the example shown in FIGS. 1 to 4, the bearing member or stationary seal member) constituting the fixed side. In one specific embodiment of the present invention, bearing (or seal) structures were constructed using the combinations of materials shown in Table 3-1, for the rotating member and stationary member. Table 3-2 shows the results of friction tests conducted under test conditions shown in Table 3-3 using the combinations of materials shown in Table 3-1. To examine the friction and abrasion characteristics of the combined materials, the bearing (seal) structures were generally configured as shown in FIG. 13 so as to be suitable for a tester rather than being configured as shown in FIGS. 1 to 4. In the above configuration, a base material 33 having a polycrystalline diamond film 37 formed on the surface is fixed to the tip of a rotating shaft 32. The base material 33 is rotated around the rotating shaft 32. A stationary ring 34 on which a polycrystalline diamond film 37 is formed is placed opposite a surface of the base material 33 on which the polycrystalline diamond film 37 is formed. The base material 33 is shaped like a ring and has an outer diameter of 10 to 50 mm. The stationary ring 34 is shaped like a ring and has an outer diameter of 12 to 60 mm.

The friction and abrasion tester configured as described above was used to carry out experiments in the air at room temperature. The pressure exerted on the surface of the base material 33 on which the diamond coat 37 was formed was controlled to be from 0.1 to 1.0 MPa. Peripheral speed was controlled to be from 0.2 m/s. Traveling distance was controlled to be from 1,000 to 5,000 m. The coefficient of friction was examined under these conditions.

The structure in accordance with the present invention has a smaller coefficient of friction than Comparative Example 1 relating to the conventional art. The structure in accordance with the present invention is thus subjected to a less intense friction than the conventional art.

**Table 3-1 Combined Materials**

| | Rotating Member | | | Fixed Ring | | |
|---|---|---|---|---|---|---|
| | Base Material | Coating Material | Film Thickness (µm) | Base Material | Coating Material | Film Thickness (µm) |
| Conventional Example 1 | SiC | - | - | SiC | - | - |
| Conventional Example 2 | SiC | - | - | WC-based Cemented Carbide | - | - |
| Conventional Example 3 | SiC | DLC | 1 | SiC | - | - |
| Conventional Example 4 | SiC | DLC | 1 | WC-based Cemented Carbide | - | - |
| Conventional Example 5 | SiC | DLC | 1 | SiC | DLC | 1 |
| Conventional Example 6 | SiC | DC | 5 | SiC | DC | 5 |
| Embodiment 1 | SiC | DC Composite Material | 5 | SiC | DC Composite Material | 5 |
| Embodiment 2 | SiC | DC Composite Material | 5 | SiC | - | - |
| Embodiment 3 | SiC | DC Composite Material | 5 | SiC | SiC Coating Material | 5 |
| Embodiment 4 | SiC | DC Composite Material | 5 | WC-based Cemented Carbide | - | - |
| Embodiment 5 | SiC | DC Composite Material | 5 | Al₂O₃ | - | - |
| Embodiment 6 | SiC | DC Composite Material | 5 | SiC | TiN coating Material | 4 |
| Embodiment 7 | SiC | DLC/DC Coating Material | 5 | SiC | DLC/DC Stacked Film | 5 |
| Embodiment 8 | SiC | DLC/DC Coating Material | 5 | SiC | - | - |
| Embodiment 9 | SiC | DLC/DC Coating Material | 5 | SiC | SiC Coating Material | 5 |
| Embodiment 10 | SiC | DLC/DC Coating Material | 5 | WC-based Cemented Carbide | - | - |
| Embodiment 11 | SiC | DLC/DC Coating Material | 5 | Al₂O₃ | - | - |
| Embodiment 12 | SiC | DLC/DC Coating Material | 5 | SiC | TiN coating Material | 4 |

| | | | | | | |
|---|---|---|---|---|---|---|
| Footnotes DLC: Diamond Like Carbon Film Produced by the Plasma CVD Method DC: Polycrystalline Diamond Film Produced by the Hot-filament CVD Method DC Composite Material: Mixture of Diamond and Non-diamond Produced by the Hot-filament CVD Method DLC/DC Coating Material: Diamond Like Carbon Film Formed on a Polycrystalline Diamond Film | | | | | | |

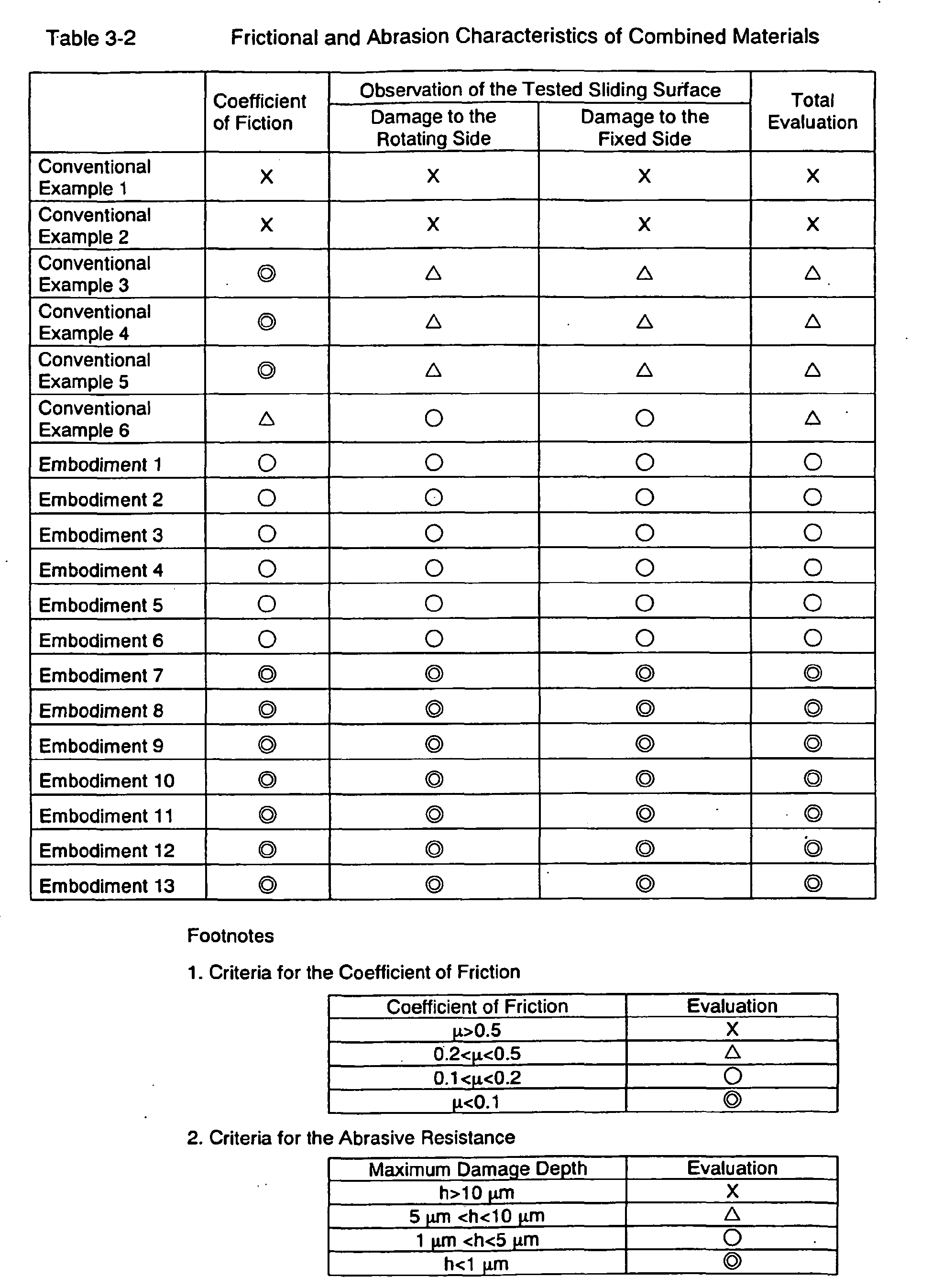

**Table 3-3Frictional Conditions**

| | |
|---|---|
| Sliding Atmosphere | In the Air |
| Contact Pressure | 0.1 - 1.0 Mpa |
| Peripheral Speed | 0.2 m/s |
| Traveling Distance | 1000 - 5000 m |

| | |
|---|---|
| Coefficient of Friction µ=3ST/2πW (R₁³-R₂³) S: Sliding Area, T: Torque, W: Pressing Load R₁: Outer Radius of the Sliding Portion, R₂: Inner Radius of the Sliding Portion | |

### [Example 4]

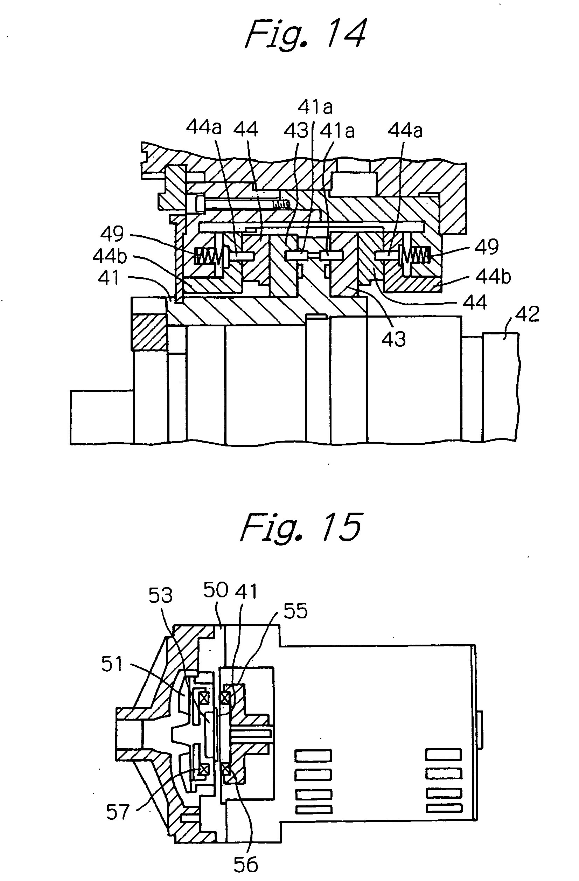

A specific example will be described in which a diamond-coated bearing or seal structure was applied in a not claimed manner to a dry gas seal for a centrifugal compressor which provides a gas such as air to a demanding end under a specified pressure. As a blower for providing a predetermined pressure and a predetermined supply flow rate, a multistage centrifugal compressor is used in which two or more of what is called radial impellers are stacked; the radial impellers provide kinetic energy to a fluid, which is then compressed by a downstream diffuser. FIG. 14 is a diagram showing an example of the configuration of a dry gas seal in the centrifugal compressor. In the figure, an axial sleeve 41 is provided on rotating shaft 42 accommodated in a seal housing. The axial sleeve 41 holds rotating rings 43, 43 (mating rings) via keys 41a, 41a. A fixed or stationary ring 44 is provided opposite each of the rotating rings 43. A SiC sintered material is used as the base material of the rotating ring 43. A thin diamond film is formed on a surface (lying opposite the stationary ring) of the base material by the hot-filament CVD method as described above. When the rotating ring comes into sliding contact with the stationary ring, the surface of the diamond coat constitutes a slidable surface. Although not shown in the drawings, a spiral groove may be formed in the slidable surface of the rotating ring 43 so as to extend from a high pressure side H to a low pressure side L.

Each of the stationary rings 44 is connected to a seal ring retainer 44b through a pin 44a. The seal ring retainer 44b is retained by the seal housing, and is pressed toward the rotating ring via a spring 49 provided between the seal housing and the seal ring retainer 44b. This also causes the stationary ring 44 to be pressed against the rotating ring 43.

In the non-contact end surface seal configured as described above, rotation of the rotating shaft 42 causes relative movement between the rotating ring 43 and stationary ring 44. This causes a fluid on the high pressure side H to be caught in the spiral groove, formed in the rotating ring 43, to form a fluid film on sealing surfaces. The fluid film brings the sealing surface into a non-contact state to form a small gap between the sealing surfaces of the rotating ring 43 and stationary ring 44.

In a normal operation mode, that is, when the outer peripheral speed of the seal ring is 2.4 m/s or higher, a kinetic pressure is exerted between the seal end surfaces to bring the dry gas seal into a non-contact state. On the other hand, during the period after the start of the compressor and before the start of the normal operation mode and the period after the start of the normal operation mode and before the stop of the compressor, the rotating seal ring and the fixed seal ring are in inter-solid contact. Accordingly, a combination of materials with an increased abrasive resistance and a reduced friction is required for slidable member. Thus, thin diamond films are formed on the slidable surfaces of a movable and stationary members consisting of a low thermal expansion material. The combination of these thin diamond films makes it possible to provide a seal member with reduced amounts of deformation and leakage, an excellent sealing capability, a reduced coefficient of friction, and a high abrasive resistance. The design shown is Fig.14 is thus suitable for a rotary machine such as a compressor dry gas seal which is operated in a process gas.

### [Example 5]

Description will be given of an example in which the present invention is applied to a thrust bearing in a magnet pump. FIG. 15 shows a diagram of the configuration of the pump. In the figure, reference numeral 50 denotes a partition plate to which a stationary member 54 constituting a thrust bearing is fixed. A movable member 53 is provided opposite the stationary member 54; the movable member 53 being fixed to an impeller 51 and constituting a thrust bearing. A permanent magnet 56 is located opposite a permanent magnet 57 via the partitioning plate 50; the permanent magnet 56 is fixed to a magnet coupling and the permanent magnet 57 is fixed to the impeller 51. Rotation of the magnet coupling 55 causes the force of the rotation to be transmitted to the impeller 51 by magnetic attractive or repulsive force acting between the permanent magnets 56 and 57. The impeller 57 is thus rotated with its thrust direction supported by the thrust bearing.

The hot-filament CVD method is used to form the thin diamond film on the slidable surfaces of the movable member 53 and stationary member 54, constituting the thrust bearing. The configuration of the thrust bearing provides a thrust bearing with excellent frictional characteristics, that is, a small coefficient of friction and a low specific carbon abrasion. Although not shown in the drawings, a radial bearing with similar characteristics may be constructed by forming thin diamond films on the slidable surfaces of movable and stationary members of the radial bearing.

In the above example, a SiC sintered material is used as a base material. However, the present invention is not limited to this. Similar effects can be exerted by using a metal material, cemented carbide, or other ceramics provided that the material has a small coefficient of thermal expansion.

In the present example, the present invention is applied to the thrust and radial bearings in the magnet pump, an example, of a feed water pump. However, the present invention is not limited to the present example. Even if the present invention is applied to a mechanical seal member in a feed water pump, similar effects can be exerted by adopting combined materials similar to those for the above thrust bearing.

In the conventional art, a bearing or seal member for a pump is composed of a combination of SiC sintered materials, a combination of a SiC sintered material and cemented carbide, or the like. However, if air is caught in the slidable portion, the coefficient of friction may increase to markedly damage the slidable surfaces. The present invention can provide combined materials exhibiting an improved abrasive resistance and a reduced friction even in the water or even if air is caught in the slidable portion.

If the conventional combined materials (SiC sintered materials vs. Sic sintered materials) are used for a bearing or seal member of a pump, which is used at a specific resistance of 10 MΩcm, for handling ultrapure water from which impurities such as particulates, bacteria, pyrogens, and dissolved oxygen have been maximally removed, then the slidable surfaces may be significantly damaged in a short time. Although the mechanism of the damage is unknown, even SiC sintered materials exhibiting a high slidability for city water cannot be used in ultrapure water. The present invention uses the diamond film, the hardest and chemically stable material, to the bearing or seal structure to enable it to exhibit excellent frictional characteristics within pure water or ultrapure water, as is clear from the description of a further embodiment.

### [Example 6]

Description will be given of an example in which the present invention is applied to a radial bearing in a vertical-axis pump for a preceding spinning reserve operation.

In a city, buildings are clustered and almost all the roads are paved. Thus, a heavy rain causes rainwater to rush into a drainage pump field without permeating into the ground. On the other hand, it takes drainage pumps in the drainage pump field a long time to complete an operation after they have been started. Consequently, drainage does not begin in time if the drainage pumps are started after the suction level in the drainage pump field has risen sufficiently. Thus, the pumps in the drainage pump field are started in the air without water simultaneously with the start of rainfall; a preceding spinning reserve operation is thus performed to wait for water to flow into the field. Therefore, the pumps perform a dry operation in the air after being started and before water starts to flow into suction tanks, thus starting actual drainage.

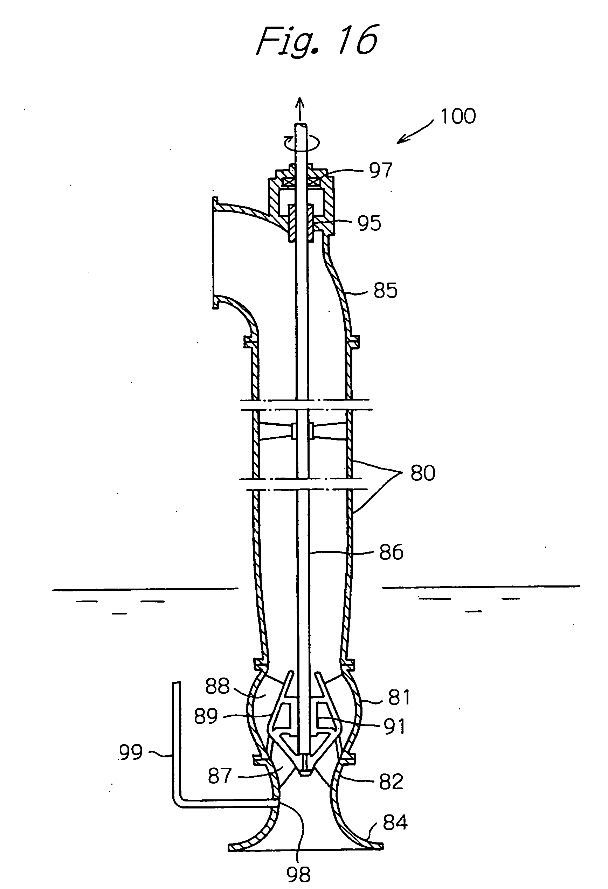

FIG. 16 is a schematic sectional view showing a conventional preceding spinning reserve operation pump of this kind. As shown in the figure, a preceding spinning reserve operation pump 100 comprises an ejection casing 81, an impeller casing 82 in which an impeller 87 is housed, a suction bell mouth 84, the ejection casing 81, impeller casing 82, and suction bell mouth 84 being attached to the bottom side of the suspended casing 80, a bent ejection casing 85 attached to the top of the hanging casing 80, and a shaft 86 installed inside the pump casings and projecting out from the top of the ejection casing 85, the shaft 86 being connected to drive means (not shown in the drawings). A guide vane 88 is fixed in the ejection casing 81. A casing 89 is installed in the center of the guide vane 88. A bearing (lower bearing) 91 for the shaft 86 is installed in the casing 89. The bearing is a water lubricated radial bearing. On the other hand, a shaft sealing portion 95 is provided around a part of the shaft 86 which projects out of the ejection casing 85, to prevent the leakage of internal pumping water. A bearing (upper bearing) 97 for the shaft 86 is provided above the shaft sealing portion. The bearing is an oil lubricated radial thrust bearing.

A through-hole 98 is formed at a position of the suction bell mouth 84 located near an inlet of the impeller. An upward folded suction pipe 99 is connected to the through-hole 98. When an operation of the pump lowers the level of the liquid to the minimum value determined on the basis of the diameter of the suction bell mouth, air is sucked through the suction pipe.

With a rotary machine such as a preceding spinning reserve operation vertical-axis pump which operates in the air, in the water, and in an air and water mixed state, no water is available for water lubrication during a dry operation (preceding operation); the water is used to lubricate or cool the bearing (lower bearing) 91. This may cause friction and generate heat to cause damage. To solve this problem, the present invention uses a diamond-coated radial bearing as one of the bearings in the preceding spinning reserve operation vertical-axis pump in which the bearings for the shaft rotatively driving the impeller installed in the pump casing is provided at the top of and inside the pump casing.

According to the present invention diamond films are formed on the slidable surfaces of movable and stationary members consisting of a low thermal expansion material. The combination of these thin diamond films makes it possible to provide a seal or bearing with reduced amounts of deformation and leakage, an excellent sealing capability, a reduced coefficient of friction, and a high abrasive resistance. The present invention is thus suitable for a rotary machine such as a preceding spinning reserve operation vertical-axis pump which operates both in the air and in the water.

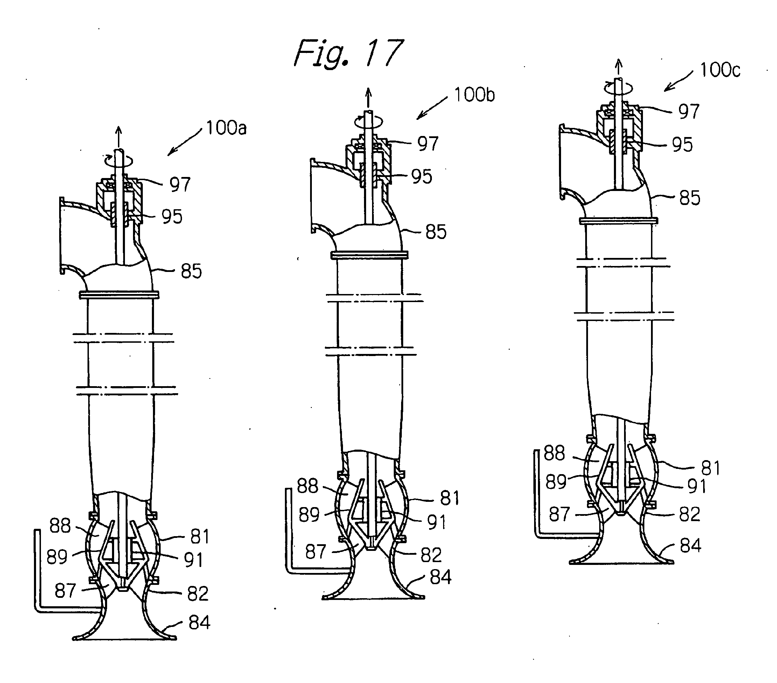

If a preceding spinning reserve operation vertical-axis pump such as the one shown in the above example is used, a plurality (for example 3, as shown in FIG. 17 in the embodiment) of such pumps 100a, 100b, and 100c, instead of only one, are arranged in parallel as shown in FIG. 17. The impeller in at least one of the plurality of vertical axis pumps has a height position different from that of the other vertical-axis pumps (the impellers in all the pumps may have different positions). This enables the pumps to sequentially drain water in order to increase impeller height as the liquid level increases so that the pump with the highest impeller starts drainage latest. This makes it possible to suppress a surge phenomenon in the suction tanks which may be caused by rapid start of drainage and to inhibit a rapid variation in the load on a power supply facility.

In contrast, if the drainage progresses to reduce the liquid level, the rapid stop of drainage can be inhibited.

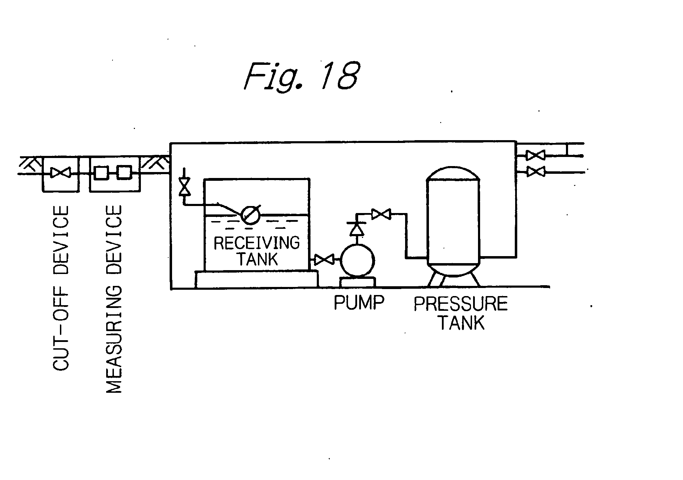

FIG. 18 schematically shows an example of a water supply apparatus to which the bearing and/or seal structure in accordance with the present invention is applicable. The water supply apparatus is based on a pressure tank system and comprises a receiving tank, a pump (storage pump), a pressure tank, and pipes connecting them together, and the like, which are shown in the drawing, as well as a lifting pipe, a high-position tank, a pump unit, a feed water pipe, and the like, which are not shown in the drawing. An appropriate pump is selected as the feed water pump in accordance with the purpose of the pump. Efficiency can be improved by applying the bearing or seal structure in accordance with the present invention.

### [Example 7]

A further embodiment of the present invention will be explained below. As in the previously described embodiments, the bearing structure (or seal structure) is composed of the movable member (in the example shown in FIGS. 1 to 4, the rotating shaft, sleeve, or movable seal member) constituting the rotating side and the stationary member (in the example shown in FIGS. 1 to 4, the bearing member or stationary seal member) constituting the fixed side. In this embodiment, the bearing structure (or seal structure) is used within pure water or ultrapure water. Respective base portions of the movable member and the stationary member are made of SiC by, for example, a sintering process. The opposing surfaces (the surface of movable member facing the stationary member and the surface of stationary member facing the movable member) of respective base portions of the movable and stationary members are coated with polycrystalline diamond. A condition and means for setting the average surface roughness of the diamond-coated surface are the same as those of the previously described embodiments. Also, the thickness of polycrystalline diamond film may be the same as that of the previously described embodiments. The material forming the bearing and seal members may be oxide-based, carbide-based or nitride-based ceramic.

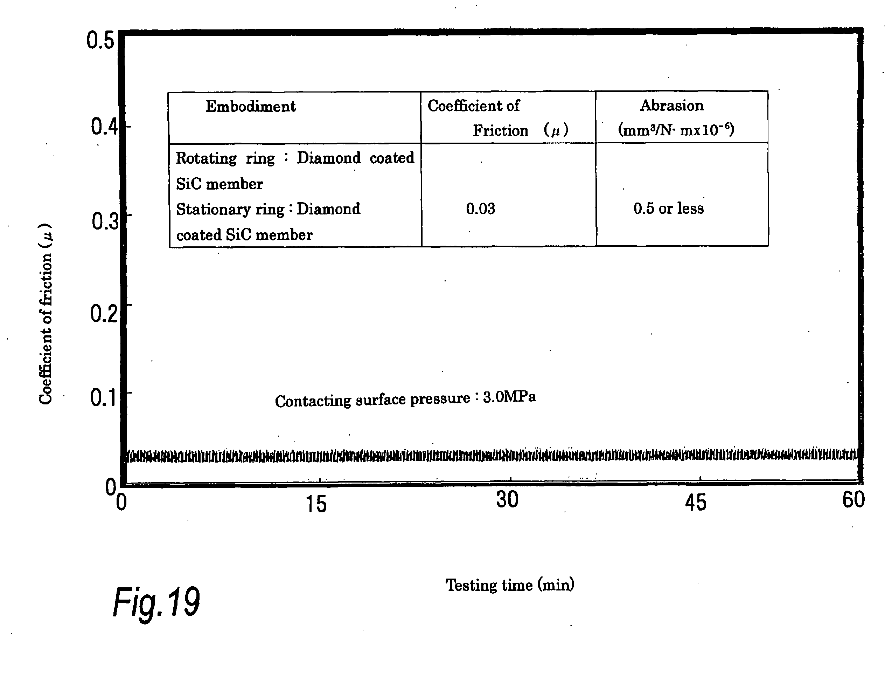

To examine the friction and abrasion characteristics of the baring or seal structure constructed as described above, an experiment has been performed within pure water (specific resistance 1.5MΩ·cm) at room temperature, using the friction and abrasion tester shown in Fig. 13, which relates to the third embodiment. Coefficient of friction was examined under the condition that the contacting surface pressure at contact surfaces of polycrystalline (CVD) diamond coated SiC members is 3 MPa, the circumferential speed is 0.5m/s and the testing time is 60 minutes. The result of the experiment is shown in Fig. 19. In this application "pure water" is defined as water having specific resistance of equal to or more than 1.0MΩ·cm and less than 10MΩ· cm, and "ultrapure water" is defined as water having a specific resistance of equal to or more than 10MΩ·cm.

As is clear from the description in Fig 19, the bearing or seal structure of this embodiment according to the present invention has acceptable low-frictional characteristics of the coefficient of friction µ = 0.03, though the experiment has been performed with contacting surface pressure being more than three times of that of the bearing structure in actual use. We found that the bearing or seal structure according to the present invention has a low coefficient of friction and develops excellent abrasive resistance (the value of abrasion of 0.5mm³/N mx10⁻⁶ or less corresponds to maximum depth of damage h < 1 µm (Ⓞ) (double circle) according to the standard of judgment shown in the footnote of table 3-2) within pure water by applying them with a CVD diamond coating. It is considered that the bearing or seal structure according to the present invention develops excellent friction and abrasion characteristics for use in ultrapure water.

Although the testing time is short, such as 60 minutes, the rotating ring rotates relative to the stationary ring with polycrystalline diamond films of these rings constantly contacting each other. On the other hand, in a bearing in actual use, surfaces of polycrystalline diamond films of bearing members do not contact each other in operation due to existence of a fluid film created therebetween by generation of a dynamic pressure. They contact with each other for a short time, such as less than a couple of minutes at the beginning and end of operation. Moreover, start and stop of the operation are not frequently practiced. Therefore, it is said that the results obtained by the short testing time of 60 minutes can be applied to the bearing or seal structure in actual use.

The bearing and seal structure for use with the present invention can be utilized in rotary machines such as pumps, turbines, and compressors.

## Claims

1. Use of a diamond-coated bearing or seal structure within pure water or ultrapure water, said bearing or seal structure having a movable member and a stationary member, wherein at least one of the movable and stationary members is made of a material having a coefficient of thermal expansion of 8 x 10⁻⁶/°C or less, a polycrystalline diamond coating being provided on said material having a coefficient of thermal expansion of 8 x 10⁻⁶/°C or less on a surface of the member which lies opposite the other member.

2. Use of the diamond-coated bearing or seal structure according to claim 1,
wherein the member different from the member coated with the polycrystalline diamond is made of one of the following: sintered SiC, cemented carbide such as tungsten carbide, chromium carbide, or titanium carbide, an oxide-based sintered material such as Al₂O₃ or ZrO₂ and a nitride-based material such as TiN.

3. Use of the diamond-coated bearing or seal structure according to claim 1 or 2, wherein the member coated with the polycrystalline diamond, is further provided with a layer of hard carbon with a Vickers hardness Hv of 2,000 < Hv < 8,000 on top of the polycrystalline diamond coating.

4. Use of the diamond-coated bearing or seal structure according to claim 3,
wherein the hard carbon layer is a diamond like carbon (DLC) layer.

5. Use of the diamond-coated bearing or seal structure according to claim 1,
wherein the polycrystalline diamond coating is a Composite material consisting of a mixture of diamond and Non-diamond.

6. Use of the diamond-coated bearing or seal structure according to claim 1,
wherein the polycrystalline diamond coating is formed by a CVD method.

7. Use of the diamond-coated bearing or seal structure according to any one of the preceding claims, wherein the polycrystalline diamond coating has an average grain size of 5 µm or less.

8. Use of the diamond-coated bearing or seal structure according to any one of the preceding claims, wherein the polycrystalline diamond coating has a thickness of 10 µm or less.

9. Use of the diamond-coated bearing or seal structure according to any one of the preceding claims, wherein diamond crystals in the polycrystalline diamond coating are highly oriented in a (100) plane.

10. Use of the diamond-coated bearing or seal structure according to any one of claims 1 to 10, wherein both the movable and stationary member are provided with a polycrystalline diamond coating provided on the surface facing the other member.

11. Use of the diamond-coated bearing or seal structure according to any one of the preceding claims, wherein the diamond-coated bearing or seal structure is part of a water supply apparatus.

12. Use of the diamond-coated bearing or seal structure according to any one of claims 1 to 10, wherein the diamond-coated bearing or seal structure is part of preceding spinning reserve operation vertical-shaft pump apparatus.

13. Use of the diamond-coated bearing or seal structure according to any one of claims 1 to 10, wherein the diamond-coated bearing or seal structure is part of compressor.

## Patentansprüche

1. Verwendung einer diamantbeschichteten Lager- oder Dichtungsstruktur in reinem Wasser oder ultrareinem Wasser, wobei die Lager- oder Dichtungsstruktur ein bewegbares Glied und ein stationäres Glied aufweist, wobei wenigstens eines der bewegbaren und stationären Glieder aus einem Material mit einem thermischen Expansionskoeffizienten von 8 x 10⁻⁶/°C oder weniger besteht, und eine polykristalline Diamantbeschichtung auf dem Material mit einem thermischen Expansionskoeffizienten von 8 x 10⁻⁶/°C oder weniger auf einer Oberfläche des Gliedes, welche dem anderen Glied gegenüberliegt, vorgesehen ist.

2. Verwendung einer diamantbeschichteten Lager- oder Dichtungsstruktur gemäß Anspruch 1, wobei das Glied, das sich von dem Glied welches mit dem polykristallinen Diamant beschichtet ist unterscheidet, aus einem der Folgenden hergestellt ist: gesintertem SiC, zementierten Karbid, wie beispielsweise Wolfram-Carbid, Chrom-Carbid oder Titan-Carbid, ein oxidbasiertes gesintertes Material, wie beispielsweise Al₂O₃ oder **ZrO₂,** und einem nitridbasierten Material, wie beispielsweise TiN.

3. Verwendung der diamantbeschichteten Lager- oder Dichtungsstruktur gemäß Anspruch 1 oder 2, wobei das Glied, das mit dem polykristallinen Diamant beschichtet ist, ferner mit einer Schicht aus hartem Karbon mit einer Vickers-Härte Hv von 2.000 < Hv < 8.000 auf der polykristallinen Diamantbeschichtung versehen ist.

4. Verwendung der diamantbeschichteten Lager- oder Dichtungsstruktur gemäß Anspruch 3, wobei die harte Karbonschicht eine diamantähnliche Karbonschicht (DLC) ist.

5. Verwendung der diamantbeschichteten Lager- oder Dichtungsstruktur gemäß Anspruch 1, wobei die polykristalline Diamantbeschichtung ein Komposit-Material ist, das aus einer Mischung aus Diamant und Nichtdiamant besteht.

6. Verwendung der diamantbeschichteten Lager- oder Dichtungsstruktur gemäß Anspruch 1, wobei die polykristalline Diamantbeschichtung durch ein CVD-Verfahren ausgebildet ist.

7. Verwendung der diamantbeschichteten Lager- oder Dichtungsstruktur gemäß einem der vorhergehenden Ansprüche, wobei die polykristalline Diamantbeschichtung eine durchschnittliche Körnchengröße von 5 µm oder weniger besitzt.

8. Verwendung der diamantbeschichteten Lager- oder Dichtungsstruktur gemäß einem der vorhergehenden Ansprüche, wobei die polykristalline Diamantbeschichtung eine Dicke von 10 µm oder weniger besitzt.

9. Verwendung der diamantbeschichteten Lager- oder Dichtungsstruktur gemäß einem der vorhergehenden Ansprüche, wobei Diamantkristalle in der polykristallinen Diamantbeschichtung stark in einer (100) Ebene orientiert sind.

10. Verwendung der diamantbeschichteten Lager- oder Dichtungsstruktur gemäß einem der Ansprüche 1 bis 9, wobei sowohl das bewegbare als auch das stationäre Glied mit einer polykristallinen Diamantbeschichtung versehen sind, die auf der Oberfläche vorgesehen ist, welche zu dem anderen Glied weist.

11. Verwendung der diamantbeschichteten Lager- oder Dichtungsstruktur gemäß einem der vorhergehenden Ansprüche, wobei die diamantbeschichtete Lager- oder Dichtungsstruktur Teil einer Wasserversorgungsvorrichtung ist.

12. Verwendung der diamantbeschichteten Lager- oder Dichtungsstruktur gemäß einem der Ansprüche 1 bis 10, wobei die diamantbeschichtete Lager- oder Dichtungsstruktur Teil einer Vertikalwellenpumpvorrichtung mit vorlaufendem Rotationsreservebetrieb ist.

13. Verwendung der diamantbeschichteten Lager- oder Dichtungsstruktur gemäß einem der Ansprüche 1 bis 10, wobei die diamantbeschichtete Lager- oder Dichtungsstruktur Teil eines Kompressors ist.

## Revendications

1. Utilisation d'une structure de palier ou d'étanchéité revêtue de diamant dans de l'eau pure ou de l'eau ultra pure, ladite structure de palier ou d'étanchéité comportant un élément mobile et un élément fixe, au moins l'un de l'élément mobile et de l'élément fixe étant en un matériau ayant un coefficient de dilation thermique de 8x10⁻⁶/°C ou moins, un revêtement en diamant polycristallin étant prévu sur le matériau ayant un coefficient de dilatation thermique de 8x10⁻⁶/°C ou moins sur une surface de l'élément qui se trouve à l'opposé de l'autre élément.

2. Utilisation de la structure de palier ou d'étanchéité revêtue de diamant selon la revendication 1, dans laquelle l'élément différent de l'élément revêtu de diamant polycristallin est en l'un des matériaux suivants : du SIC frité, du carbure cémenté tel que du carbure de tungstène, du carbure de chrome ou du carbure de titane, un matériau frité à base d'oxyde tel que Al₂O₃ ou ZrO₂ et un matériau à base de nitrure tel que TiN.

3. Utilisation de la structure de palier ou d'étanchéité revêtue de diamant selon la revendication 1 ou 2, dans laquelle l'élément revêtu de diamant polycristallin est en outre muni d'une couche de carbone dur ayant une dureté de Vickers Hv telle que 2000 < Hv < 8000 par-dessus le revêtement de diamant polycristallin.

4. Utilisation de la structure de palier ou d'étanchéité revêtue de diamant selon la revendication 3, dans laquelle la couche de carbone dur est une couche de carbone similaire à du diamant (DLC).

5. Utilisation de la structure de palier ou d'étanchéité revêtue de diamant selon la revendication 1, dans laquelle le revêtement de diamant polycristallin est un matériau composite constitué d'un mélange de diamant et de non diamant.

6. Utilisation de la structure de palier ou d'étanchéité revêtue de diamant selon la revendication 1, dans laquelle le revêtement de diamant polycristallin est formé par un procédé CVD.

7. Utilisation de la structure de palier ou d'étanchéité revêtue de diamant selon l'une quelconque des revendications précédentes, dans laquelle le revêtement de diamant polycristallin a une taille de grain moyenne inférieure ou égale 5 µm.

8. Utilisation de la structure de palier ou d'étanchéité revêtue de diamant selon l'une quelconque des revendications précédentes, dans laquelle le revêtement de diamant polycristallin a une épaisseur inférieure ou égale à 10 µm.

9. Utilisation de la structure de palier ou d'étanchéité revêtue de diamant selon l'une quelconque des revendications précédentes, dans laquelle les cristaux de diamant dans le revêtement de diamant polycristallin sont fortement orientés dans un plan (100).

10. Utilisation de la structure de palier ou d'étanchéité revêtue de diamant selon l'une quelconque des revendications 1 à 10, dans laquelle l'élément mobile et l'élément fixe sont tous deux munis d'un revêtement de diamant polycristallin sur la surface opposée à l'autre élément.

11. Utilisation de la structure de palier ou d'étanchéité revêtue de diamant selon l'une quelconque des revendications précédentes, dans laquelle la structure de palier ou d'étanchéité revêtue de diamant fait partie d'un appareil d'approvisionnement en eau.

12. Utilisation de la structure de palier ou d'étanchéité revêtue de diamant selon l'une quelconque des revendications 1 à 10, dans laquelle la structure de palier ou d'étanchéité revêtue de diamant fait partie d'une pompe à arbre vertical à fonctionnement à réserve tournante précédente.

13. Utilisation de la structure de palier ou d'étanchéité revêtue de diamant selon l'une quelconque des revendications 1 à 10, dans laquelle la structure de palier ou d'étanchéité revêtue de diamant fait partie d'un compresseur.
